Europäisches Patentamt

**European Patent Office**

Office européen des brevets

(11) Publication number: **0 276 113**
**A2**

## EUROPEAN PATENT APPLICATION

(21) Application number: **88300382.4**

(22) Date of filing: **19.01.88**

(51) Int. Cl.⁴: **H 03 K 17/95**
**E 05 B 49/00**

(30) Priority: **21.01.87 GB 8701221**

(43) Date of publication of application:
**27.07.88 Bulletin 88/30**

(84) Designated Contracting States:
**AT BE CH DE ES FR GB GR IT LI LU NL SE**

(71) Applicant: **Harley, Christopher James**
**9 Cheshire Way Southbourne**
**Emsworth Hampshire PO10 8PU (GB)**

**Howells, Geoffrey Winwood**
**24 Pitreavie Road**
**Cosham Portsmouth Hampshire PO6 2ST (GB)**

(72) Inventor: **Harley, Christopher James**
**9 Cheshire Way Southbourne**
**Emsworth Hampshire PO10 8PU (GB)**

**Howells, Geoffrey Winwood**
**24 Pitreavie Road**
**Cosham Portsmouth Hampshire PO6 2ST (GB)**

(74) Representative: **Prutton, Roger et al**
**MARKS & CLERK Alpha Tower Suffolk Street Queensway**
**Birmingham B1 1TT (GB)**

(54) Code device recognition system and access control system using such recognition system.

(57) A code device recognition system comprises a transmitting coil (12) driven by an oscillator (14), an overlapping receiving coil (13) connected to a detector, and a code device (11) including a coil (15). The overlap of the coils is arranged so that the receiving coil is not magnetically coupled with the transmitting coil. The code device includes a switch element (16) for completing a circuit through the coil (15) and a control device for operating this switch element in a predetermined code sequence. When the code device is within range of the transmitting and receiving coils, it creates a secondary magnetic field, detectable by a detector connected to the receiving coil, only when the switch element is closed. The detector can thus read the code and compare it with at least one stored code to issue a recognition signal. The coil (15) also preferably drives a rectifier circuit to provide power for the control circuit 17.

FIG.I.

## Description

### CODE DEVICE RECOGNITION SYSTEM AND ACCESS CONTROL SYSTEM USING SUCH RECOGNITION SYSTEM

This invention relates to a code device recognition system which is suitable for operating door locks and other systems for controlling access to buildings or parts of buildings.

Various code device reading systems are currently in use which make use of punched or magnetically or otherwise coded cards and the like to control locks and the like. Such systems normally require the user to insert the key card into a slot in a reading device or otherwise present for reading.

Locking systems also exist in which the key contains a power source which is used to energise a transmitting device, such as an infra-red radiation emitter which can transmit a coded signal to a code recognition device incorporated in a lock. Such keys consume significant quantities of electrical energy and require periodic recharging or replacement of the power source.

In accordance with the invention there is provided a code device recognition system comprising a transmitter device for creating an alternating magnetic field in a zone adjacent said transmitter device; at least one code device including a coil, a switching element interconnecting the ends of said coil and a control circuit for said switching element, said control circuit operating to switch the switching element on and off in accordance with a predetermined code; and a detector device arranged to detect when the switching element of the code device is switched on within the alternating magnetic field and to compare the coded signal detected with at least one acceptable code.

Preferably the coil of the code device is also connected to a rectifier circuit arranged to supply power to said control circuit.

Preferably the transmitter device and the detector device each includes a flat coil, the transmitter coil and the receiver coil being arranged in an overlapping relationship such that the receiver coil is in a null position relative to the transmitter coil.

An example of the invention is shown in the accompanying drawings in which:

Figure 1 is a simplified block diagram showing a code device recognition system included in an access control system;

Figure 2 is a detailed circuit diagram of an oscillator included in the system;

Figure 3 is a detailed circuit diagram of a detector included in the system;

Figure 4 is a flow chart for software used by a microcomputer included in the detector of Figure 3; and

Figure 5 is a detailed circuit diagram of a code device included in the system of Figure 1.

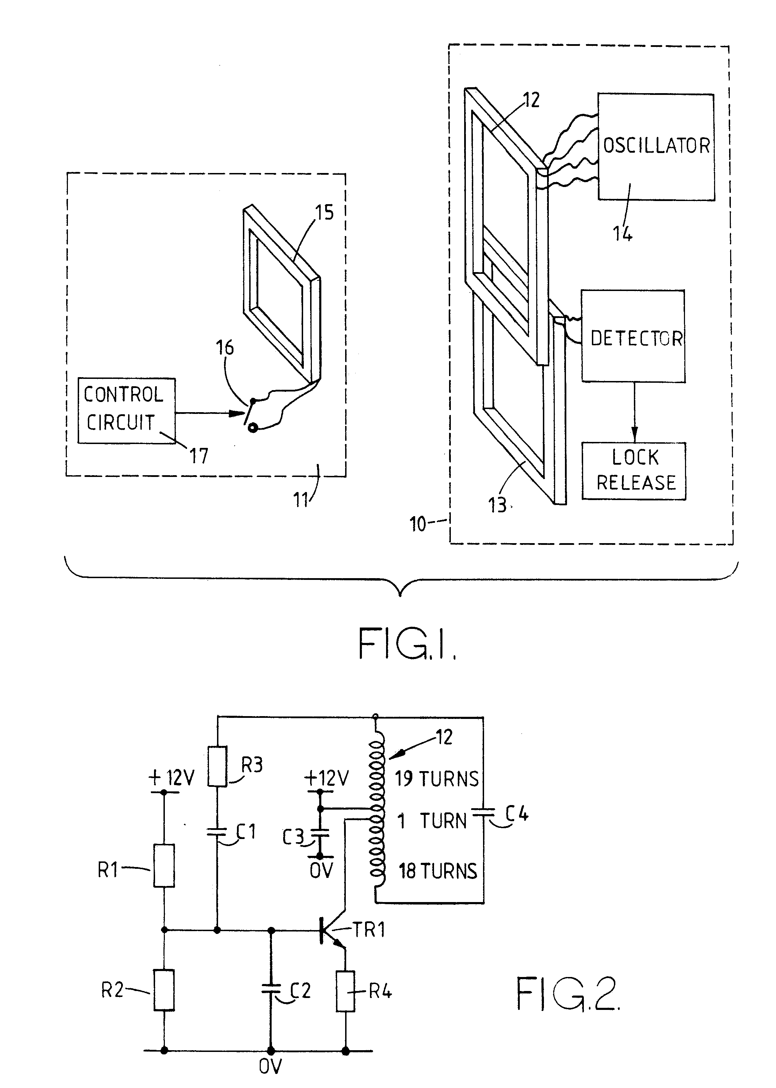

Referring firstly to Figure 1, the access control system includes a number of lock stations 10 each controlling the lock of a door and a plurality of code devices 11 for issue to the persons who require to open the doors. Generally, each code device 11 is preset to have a different code associated with it and each lock station is provided with a memory device of some type which stores data representing the codes of all the coded devices which are to be permitted to cause opening of the associated lock.

The lock station 10 includes two flat, overlapping multi-turn coils, one, 12, of which is a transmitting coil, and the other, 13, of which is a receiving coil. These two coils are arranged relative to one another so that the receiving coil 13 is at a null position relative to the coil 12, which is driven by an oscillator 14 so as to produce an alternating magnetic field in a zone adjacent the lock station. Such null position is found by adjusting the overlap of the two coils until there is no alternating voltage induced in the receiving coil 13 as a result of the alternating magnetic field created by the coil 12.

The oscillator 14 is shown in detail in Figure 2. The oscillator includes an npn transistor $TR_1$ which has its base connected to the junction of two resistors $R_1$ and $R_2$ which are connected in series between a +12V rail and ground. The collector of transistor $TR_1$ is connected to a point on the winding 12 which, in the example shown, has 38 turns. The connection between the collector of transistor $TR_1$ and the coil 12 is eighteen turns from one end of the coil. Another point on the coil, one turn further from said one end, is connected to the +12V rail. The other end of coil 12 is connected by a resistor $R_3$ and a capacitor $C_1$ in series to the base of the transistor $TR_1$ and a further capacitor $C_2$ connects the base of transistor $TR_1$ to the ground rail. A capacitor $C_3$ is connected between said other point on the coil 12 and the ground rail. A capacitor $C_4$ is connected across the entire coil 12. A resistor $R_4$ connects the emitter of transistor $TR_1$ to the ground rail.

The oscillator is a Hartley-type oscillator. The resistor $R_1$ provides a low level initial current at power-up to start the oscillator running. Resistors $R_2$ and $R_3$ and capacitors $C_1$ and $C_2$ form a Wien bridge circuit which applies to the base of transistor $TR_1$ a positive feedback signal. Connection of the collector of transistor $TR_1$ to a point just one turn from the power supply connection instead of to the more usual point at the "lower" end of the coil 12, enables the circuit to operate as a power oscillator. The resistor $R_4$ limits the current in transistor $TR_1$.

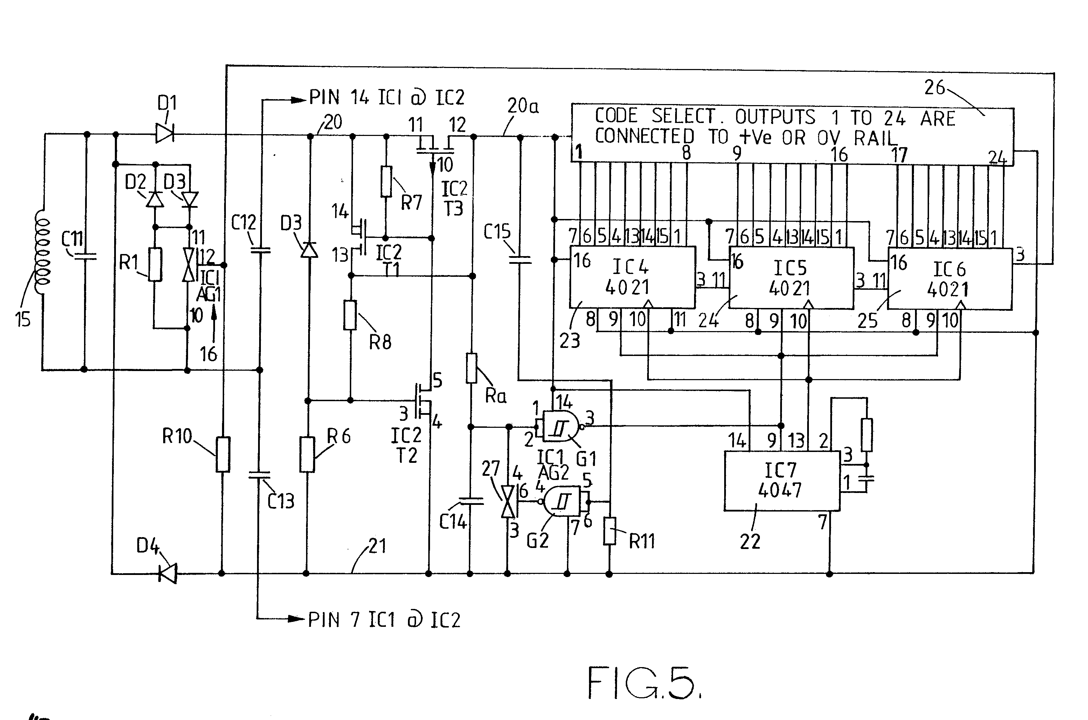

The system of Figure 1 also includes the code device 11 which is shown in detail in Figure 5. In principle, the code device includes a coil 15, a switch device 16 connected to complete a circuit through the coil and a control circuit 17 for the switch device 16. When the code device 11 is within the aforementioned zone adjacent the transmitting coil 12 an alternating e.m.f. is induced in the coil 15. When the switch device 16 is closed alternating current can flow in the coil 15 which creates its own alternating magnetic field which induces an e.m.f. in the receiving coil 13. When the switch device 16 is open however, no such current can flow and no e.m.f. is induced in the receiving coil 13. The control circuit 17 is arranged so as, when the coil 15 is within the zone, it opens and closes the switch element in a sequence dependent on a code stored in the control circuit.

The code device is ideally in form of a credit-card size plastics card with the coil 15 wound around its periphery and the switch device 16 and control circuit 17 included as a single chip integrated circuit (possibly with some discrete components) mounted on the card and connected to the coil. The following description, however, relates to a prototype control circuit in which conventional integrated circuit components are used. The skilled reader will understand that the various components identified can readily be incorporated in a special purpose integrated circuit. The control circuit described not only controls the switch device 16, but also includes a rectifier and voltage multiplier circuit to enable the e.m.f. induced in the coil 15 when the switch device 16 is open, to provide power for the control circuit. No battery is thus required.

The detailed circuit of the control circuit, shown in Figure 5, includes a CMOS analog gate device (part of a 4066 type CMOS integrated circuit) as the switch device 16. The coil 15 has a capacitor $C_{11}$ connected across it, such that the coil 15 and capacitor $C_{11}$ form a series resonant circuit which is tuned to the frequency of the oscillator 14 (which may, for example, be in the region of 135KHz). The rectifier and voltage multiplier circuit referred to above comprises two diodes $D_1$ and $D_4$ which connect one end of coil 15 to opposite ends of a series circuit comprising two capacitors $C_{12}$ and $C_{13}$. The common point of these two capacitors is connected to the other end of coil 15. The capacitors $C_{12}$ and $C_{13}$ act as storage devices and are charged by the coil 15 to positive and negative peak voltages respectively so that the total voltage across the two capacitors in series is almost equal to the peak-to-peak voltage induced in the coil 15. The series circuit consisting of the two capacitors $C_{12}$ and $C_{13}$ is connected between two power supply rails, 20, 21.

A zener diode $D_5$ has its cathode connected to rail 20 and its anode connected by a resistor $R_6$ to the rail 21. The anode of zener diode $D_5$ is connected to the gate terminal of a mosfet $T_2$ which actually forms part of a 4007 type CMOS integrated circuit. The drain terminal of this mosfet is connected to the rail 21 and its source terminal is connected to the gate terminal of another mosfet $T_3$ forming part of the same integrated circuit. The drain terminal of the mosfet $T_3$ is connected to the rail 20 and its source terminal is connected to a rail 20a. The drain terminal of the mosfet $T_2$ is also connected to the gate terminal of a third mosfet $T_1$ forming yet another part of the same integrated circuit. The drain terminal of mosfet $T_1$ is connected to rail 20 and its source terminal is connected to the rail 20a. In addition a resistor $R_7$ connects the rail 20 to the gates of mosfets $T_1$ and $T_3$ and a resistor $R_8$ connects the source terminal of mosfet $T_1$ to the gate of the mosfet $T_2$.

Initially, when the code device is not in the alternating magnetic field, the three mosfets are all biased off by resistors $R_6$ and $R_7$. When the voltage between rails 20 and 21 becomes sufficient to break down the zener diode $D_5$, the mosfet $T_2$ starts to conduct and mosfets $T_1$ and $T_2$ therefore also start to conduct. As a result of the presence of resistor $R_8$ there is regenerative feedback to the base of mosfet $T_2$ and all three mosfets are therefore turned fully on rapidly.

The rail 20a provides the power supply to another CMOS integrated circuit (type 4093) which consists of two Schmitt input NAND gates $G_1$ and $G_2$. The gate $G_1$ has its two inputs connected together and connected by a resistor $R_9$ to the rail 20a and by a capacitor $C_{14}$ to the rail 21. When the mosfet $T_3$ turns on as described above, power is supplied to the gate $G_1$, but since the capacitor $C_{14}$ is initially in a discharged state the output of gate $G_1$ is initially high. After a delay determined by the time constant of $R_9$ and $C_{14}$, the output of the gate $G_2$ goes low. The gate $G_1$ output is used for initialising the succeeding parts of the control circuits.

These parts consist of a clock oscillator in the form of a CMOS multivibrator integrated circuit 22 (type 4047) and a shift register consisting of three cascaded CMOS parallel-in, serial out static shift register integrated circuits 23, 24, 25 (all type 4021).

The output of gate $G_1$ is connected to the parallel/serial control terminal of all three shift register integrated circuits and to the external reset and trigger input of the multivibrator integrated circuit 22. During the time for which the output of gate $G_1$ is high the clock oscillator is disabled, but the shift registers 23 to 25 are loaded with parallel data from a code select array 26. This array comprises a series of connections from the various parallel data input terminals of the shift registers 23 to 25 either to the rail 20a or to the rail 21 in accordance with whether the associated bit of the code is to be a 1 or a 0. The first bit is always a 1. When the output of gate $G_1$ goes low, the oscillator starts to run and the code is clocked bit by bit from the serial output terminal of shift register circuit 25.

This serial output terminal is connected to the control terminal of the analog gate 16. This gate has its signal terminals connected in series with a pair of oppositely connected diodes $D_2$ and $D_3$ across the coil 15. Thus when the code bit is a 1 the gate 16 is conductive and when it is a 0 the gate 16 is non-conductive and the code is thus transmitted. A resistor $R_{10}$ connects the control terminal of the gate 16 to rail 21 to keep gate 16 non-conductive except when signals are received from the shift register.

The other gate $G_2$ is used to reset the control circuit after an interval longer than that required to transmit the code. Gate $G_2$ has its inputs connected together and connected by a capacitor $C_{15}$ to the rail 20a and by a resistor $R_{11}$ to the rail 21. When mosfet $T_3$ turns on the output of gate $G_2$ is held low for a time dependent on the time constant of resistor $R_{11}$ and capacitor $C_{15}$. The output of gate $G_2$ is connected to the control terminal of another analog gate 27 (forming part of the aforementioned 4066-type CMOS i.c.) which has its signal path connected across the capacitor $C_{14}$.

When the output of gate $G_2$ goes high after transmission has been completed the analog gate 27 discharges not only capacitor $C_{14}$, but also the

power supply storage capacitors $C_{12}$ and $C_{13}$ so that the whole cycle recommences.

It is of significance, as will be explained hereinafter, that the time taken between a reset and the next initialisation pulse from gate $G_1$ is dependent on the magnetic field strength and therefore on the distance between the code device and the transmitting coil. This variable time delay results from the rate of charging of the capacitors $C_{12}$ and $C_{13}$ being dependent on the e.m.f. induced in the coil 15.

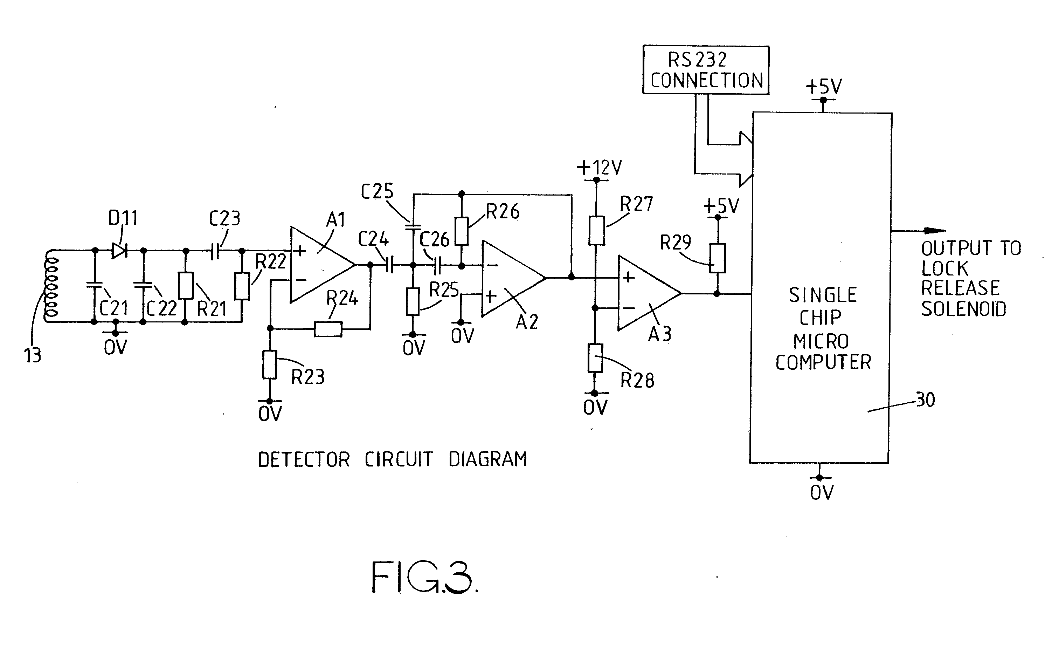

The receiving coil 13 of Figure 1 is connected to a detector which is shown in detail in Figure 3. The detector includes a capacitor $C_{21}$ connected across the coil 13 and forming a series tuned circuit tuned to the frequency of the oscillator 14. A diode $D_{11}$ has its anode connected to one end of the coil 13 and its cathode connected by a capacitor $C_{22}$ to the other end of coil 13 (which other end is grounded). A resistor $R_{21}$ is connected across the capacitor $C_{22}$ and a d.c. blocking capacitor $C_{23}$ connects the cathode of the diode $D_{11}$ to the non-inverting input terminal of an operational amplifier $A_1$. A resistor $R_{22}$ connects this non-inverting input terminal to ground. The inverting input of amplifier $A_1$ is connected to ground by a resistor $R_{23}$ and to the amplifier output terminal by a resistor $R_{24}$. The resistors $R_{23}$ and $R_{24}$ are chosen to provide a gain of about 100.

The output of amplifier $A_1$ is connected to a low pass filter constituted by resistors $R_{25}$ and $R_{26}$, capacitors $C_{24}$, $C_{25}$ and $C_{26}$ and an operational amplifier $A_2$. This filter has a cut-off frequency of about 200Hz and serves to prevent the detector from acting as a simple metal detector (detecting changes of position of a metal object passing through the zone).

The output of amplifier $A_2$ is connected to the non-inverting input of a voltage comparator $A_3$, the inverting input of which is connected to a reference voltage source comprising two resistors $R_{27}$ and $R_{28}$ in series between a $+12V$ supply rail and ground. The comparator $A_3$ has its output connected to an input terminal of a single chip microcomputer 30 (such as a 6805 integrated circuit).

The diode $D_{11}$ and capacitor $C_{22}$ form a peak store which is discharged by the resistor $R_{21}$. The a.c. component of the signal on resistor $R_{21}$ is amplified and filter and formed into a well squared waveform by the comparator $A_3$.

The microcomputer is required to receive the trains of pulses from the comparator $A_3$ (which pulse trains represent the codes stored in code device which pass through the zone) and determine whether any such code is an acceptable code for the door in question.

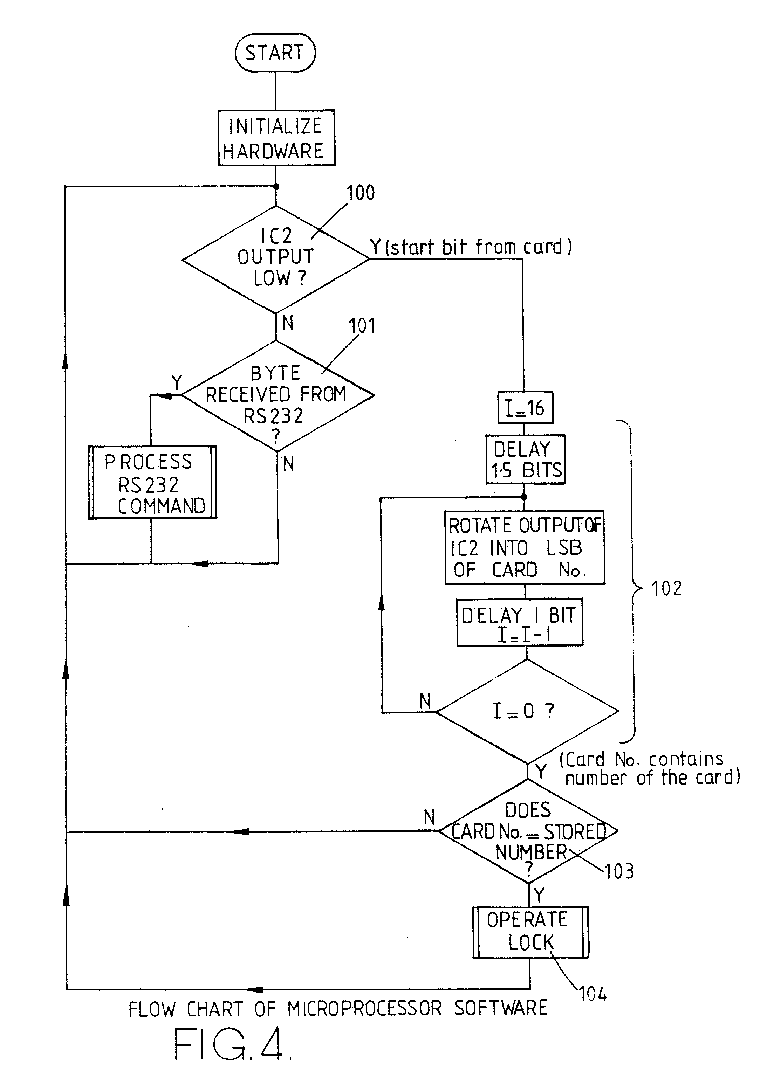

Figure 4 shows a simplified flow chart of software installed in a ROM area in the microcomputer. The software distinguishes signals from the comparator from signals received at an RS232 input of the computer, reads the code bit by bit into its memory, compares this with stored codes and outputs a lock release signal if a match is found.

As shown the software checks 100 whether the output of $A_3$ is low periodically. (Since the filter amplifier $A_2$ is connected to operate in inverting mode a low signal from comparator $A_3$ corresponds to a bit value of 1 in the code sequence emitted by the code device). If it is not a check 101 is made to establish if an input byte has been received at the RS232 port. If such a byte has been received the RS232 command is processed before returning to the original check 100.

If the $A_3$ output is found to be low then a code input routine 102 is started by setting a counter I to 16 and looping through a bit by bit input sequence with an appropriate delay in the loop. When the counter I has counted out a check 103 is made to compare the variable CARDNO, established by rotating the individual $A_3$ output states in successive executions of the loop into the LSB of CARDNO, with numbers stored in the ROM of the microcomputer. If no match is found the program returns to step 100 otherwise a lock release signal is output 104 before such return.

It will be understood by the skilled reader that the code device recognition system described above is capable of very considerable elaboration. For example the software may include the steps of measuring the duration of the first bit of the code (which is always 1) and using this measurement to establish the delay required in the loop 102.

It will also be understood that the very simple embodiment described is not suitable for the transmission of the whole range of $2^{16}$ codes capable of being recognised by the microcomputer. For example a code consisting of all 1s or all 0s cannot be used. Various known techniques, such as the use of Manchester codes, can be used to extend the range of codes available.

The very simple code receiving algorithm used means that the microcomputer will simply sample the $A_3$ output at sixteen equally spaced instants. If there happen to be two code devices within range of the transmitter at the same time, the code collected could therefore be a mixture of the codes from the two code devices. The variable delay between transmission cycles from the code devices overcomes this problem. Since the transmissions from the two code devices will restart following different delay periods a complete transmission from each key will eventually be properly collected and used to operate the lock if it matches a stored code.

Code sequences longer than 16 bits can, of course, be used if required.

The computer program may, of course, be extended to include many other functions if required, such as the recordal of dates and times of usage of the various code devices.

It is worthy of note that, when the system of the invention is used in an access control system, there is no need for the holder of the card to take any action to initiate unlocking of a door. He may simply carry the code device in a pocket and, provided the card is not magnetically shielded by anything he is carrying the lock will automatically open on his approach (if it is intended that he should have access to the area controlled by that lock).

## Claims

1. A code device recognition system comprising a transmitter device for creating an alternating magnetic field in a zone adjacent said transmitter device; at least one code device including a coil, a switching element interconnecting the ends of said coil and a control circuit for said switching element, said control circuit operating to switch the switching element on and off in accordance with a predetermined code; and a detector device arranged to detect when the switching element of the code device is switched on within the alternating magnetic field and to compare the coded signal detected with at least one acceptable code.

2. A system as claimed in claim 1 in which the coil of said code device is also connected to a rectifier circuit arranged to supply power to said control circuit.

3. A system as claimed in claim 2 in which said control circuit includes initialising means sensitive to said rectifier circuit for initiating a code transmission sequence.

4. A system as claimed in claim 3 in which said control circuit also includes reset means for resetting said initialising means after a predetermined time lapse.

5. A system as claimed in claim 1 in which there is a delay between resetting and re-initialising dependent on the strength of the magnetic field in which the code device is located.

6. A system as claimed in claim 1 in which said transmitter device and said detector device each includes a flat coil, the transmitter coil and the receiver coil being arranged in an overlapping relationship such that the receiver coil is in a null position relative to the transmitter coil.

7. A system as claimed in claim 6 in which said detector device includes a low pass filter arranged to prevent detection of ordinary metal objects in said zone.

8. A system as claimed in claim 1 in which the code device is in the form of a plastics card with the coil around its periphery and the control circuit and switch element mounted on the card.

9. A system as claimed in claim 1 in which the code device includes a capacitor connected to said coil and forming in combination therewith a series resonant circuit tuned to the frequency of said oscillator.

FIG.1.

FIG.2.

DETECTOR CIRCUIT DIAGRAM

FIG.3.

0276113

04·02·88

FLOW CHART OF MICROPROCESSOR SOFTWARE

FIG.4.

FIG.5.